# EUROPEAN PATENT APPLICATION

(11) **EP 0 800 337 A1**
(43) Date of publication of application: **08.10.1997**
(21) Application number: 97830140.6
(22) Date of filing: 25.03.1997
(51) Int. Cl.: H05K 3/46

(54) **Blocking system for holding multilayer printed circuit boards in place during polymerisation of the intermediate insulating sheets**

(30) Priority: 05.04.1996 IT MC960043
(71) Applicant: SO.MA.CI.S. - S.p.A., 60022 Castelfidardo (AN) (IT)
(72) Inventor: Volpi, Pierluigi, Recanati (MC) (IT)
(74) Representative: Baldi, Claudio

(57) **Abstract**

This present invention concerns a system for blocking multilayer printed circuit boards during press polymerisation of the intermediate insulating sheets and is characterised in that it provides a series of welding spots along the edges of the multilayer packet.

## Description

This patent application concerns a system for keeping multilayer printed circuit boards blocked during press polymerisation of the intermediate insulating sheets.

Patent protection is also to be extended to the article manufactured with the new system which is the object of such patent application.

As operators in this industrial sector well know, multilayer printed circuit boards are made of a packet of boards, each of which bearing circuit tracks printed on its opposed sides; between one board and the other, very thin sheets are interposed which insure the electrical insulation of the interfacing tracks on the couples of adjoining boards.

Such sheets are generally made of a special textile glass soaked with epoxy resins at a non polymerised stage.

Once such a multilayer packet is formed, it must undergo a pressing and heating phase by means of specially designed presses.

To begin with, the pressure applied to the multilayer packet compacts the various layers expelling all the air between them, while such air is sucked from the outside by a vacuum which these special presses are designed to create for this purpose.

Heating of the pressed packet, on the other hand, is performed in order to first melt the epoxy resins until they are fluidified and then polymerise them, in such a way as to "fuse" together and consolidate the various boards in the packet, which, once firmly joined together, constitute the semimanufactured product commonly referred to as "multilayer laminate".

During the above mentioned polymerisation phase, the problem arises of holding the boards of the multilayer packet firmly in place; in fact, when the epoxy resin the intermediate sheets are soaked in becomes fluid, the boards tend to slide on each other.

It is obvious that even the slightest shifting of just one board can compromise the exact prearranged alignment of the boards' superimposed tracks, affecting its precision and, consequently, the proper functioning of the circuit.

One of the systems devised to firmly block all the boards of the multilayer packet consists in using a supporting tray with a perimeter series of jutting dowel and lock pins, which are fitted into corresponding holes made along the edges of all of the boards, including the intermediate sheets; boards and sheets must be lowered one by one in the right order onto such tray, which is provided with an upper counter-tray that is shut and locked onto the multilayer packet.

One of the main drawbacks of said system is its high production cost, owing particularly to the cost of the above mentioned supporting tray, whose design and manufacture are rather demanding, because of the need to adopt and respect the strictest and most precise allowances, given the different degrees of thermal expansion of the tray and boards, the latter being integral with each other by means of the said lock pins.

It must be remembered, moreover, that it is necessary to have a number of such expensive trays customized in different dimensions, one for each size of the "multilayer laminate" to be produced.

Another quite widespread system for blocking in place the boards of the multilayer packet during said polymerisation consists of fixing them temporarily together with a perimeter series of rivets.

Such system, although cheaper than the previous one, still implies considerable expenditure, as the manual fitting of such rivets is not practical in terms of time and labour and automation of the same procedure, on the other hand, entails buying expensive specially designed riveting machines. Moreover, it must be stressed that such rivets may cause serious inconvenience during the pressing phase of the multilayer packet, since the rivets themselves are simultaneously subjected to an axial pressure, as their two heads protrude from the two opposed sides of the packet. The rivets may buckle not strictly along their longitudinal axis, but also laterally, causing a transversal stress on the pile of riveted boards, thereby encouraging the sliding of boards on each other.

It is the object of the present invention to devise a new system for holding the multilayer printed circuit boards firmly in place during press polymerisation of the intermediate insulating sheets, free from the above listed inconveniences affecting the systems thus far adopted.

In particular, it is the main aim of the system according to the invention to devise a method which may be implemented at a low cost, dispensing with the use of machines or special - and therefore expensive - equipment.

It is an additional object of this invention to do away with the time and costs which are currently necessary for the pre-drilling of all boards and insulating sheets making up the multilayer packet, which, in accordance with the requirements of the existing systems, must have a perimeter series of through holes for fitting pins or rivets.

Not least among the aims of the present system according to the invention is to allow free and even thermal expansion of all the layers in the multilayer packet, with no recourse to any foreign body which may somehow hamper or condition such expansion.

All the above objectives are achieved by the system according to the invention as stated in the first claim.

The system according to the invention consists in providing a perimeter series of mash welding spots, aiming at making all layers in the packet integral with each other; the thermal expansion of the packet can thus find no obstacle in any foreign body for blockage, while even the least shifting of the superimposed layers is fully prevented.

Such welding spots are made simply by causing, through opposed couples of heated punches, the fluidification and polymerisation of the epoxy resin in which the intermediate insulating sheets in the packet are soaked; the packet can then be subjected to the pressing and press heating phases, to finally produce, as anticipated above, the so called "multilayer laminate".

The welding spots located along the perimeter of the "multilayer laminate" are subsequently eliminated with a dinking operation, during which the edges of the laminate are cut and discarded.

Such trimming phase is in fact the same as is currently performed when using the existing systems, in order to remove the edges which bear either the blocking rivets or the holes for the dowel pins of the aforementioned blocking trays.

## Claims

1. A system for blocking multilayer printed circuit boards during press polymerisation of the intermediate insulating sheets, characterised in that it consists in providing a series of welding spots along the edges of the multilayer packet, made up by the boards on which the tracks of the circuit are printed, using opposed couples of heated punches to cause fluidification and polymerisation of the epoxy resin soaking the insulating sheets of textile glass which are interposed between the various boards in the multilayer packet.

2. A multilayer printed circuit obtained by using the system claimed in point 1.
